# EUROPEAN PATENT SPECIFICATION

(11) **EP 3 077 773 B1**
(45) Date of publication and mention of the grant of the patent: **18.03.2020**
(21) Application number: 13802870.9
(22) Date of filing: 03.12.2013
(51) Int. Cl.: G01F 1/66, G01F 15/06, H01Q 7/00, H05K 1/14, G01D 4/00

(54) **CONSUMPTION METER COMPRISING A FOLDABLE PRINTED CIRCUIT BOARD ASSEMBLY**
VERBRAUCHSMESSGERÄT MIT FALTBARER LEITERPLATTENANORDNUNG
COMPTEUR DE CONSOMMATION COMPRENANT UN ENSEMBLE CARTE DE CIRCUIT IMPRIMÉ PLIABLE

(43) Date of publication of application: 12.10.2016
(60) Divisional application: 19214121.6
(73) Proprietor: Apator Miitors ApS, 8210 Aarhus V (DK)
(72) Inventor: DRACHMANN, Jens, DK-8260 Viby J (DK)
(74) Representative: Patentgruppen A/S
(86) International application number: PCT/DK2013/050408
(87) International publication number: WO 2015/081958

(56) References cited:
- EP-A1- 2 336 732
- EP-A2- 1 983 311
- US-B1- 6 304 231
- US-B2- 8 033 183

## Description

The present invention relates to a consumption meter, such as an ultrasonic flow meter, comprising a printed circuit board assembly, which can be folded to form a compact assembly extending in three geometric planes.

### Background of the invention

A well-known physical limitation, which can be hindering the efforts of reducing the physical size of wireless consumption meters, is the fact that the radio frequency (RF) antenna used for communication with a distant central control unit requires certain dimensions in order to obtain the appropriate resonance frequency of the antenna. Although it is possible to make RF antennas with smaller physical dimensions than normal for a given resonance frequency, it is a well-known problem that the efficiency of such small antennas is not very high.

EP 1 983 311 A2 discloses a consumption meter with three connected PCBs arranged in a U-shape enclosing the flow channel. The three PCBs include a side PCB with the antenna and a side PCB with the battery arranged in parallel planes with the flow channel between them, and a top PCB with electronics and display.

### Brief description of the invention

It is an object of the invention to provide a solution, which overcomes or at least reduces the above-mentioned problem.

The present invention is defined by the independent claims 1 and 11. The specific embodiments of the present invention are defined by the dependent claims 2-10 and 12-15.

The present invention relates to a consumption meter comprising a foldable printed circuit board assembly, which foldable printed circuit board assembly comprises a printed circuit board substrate having at least a first and a second rigid part, wherein electronic components and a battery are mounted on the first rigid part, which also comprises an electrical ground plane, and a radio frequency (RF) antenna extends mainly on the second rigid part, a first flexible part of the printed circuit board substrate being arranged to allow the printed circuit board assembly to be folded so that the first and second rigid parts extend in two different but substantially parallel geometric planes.

In an embodiment of the invention, the first flexible part connects the second rigid part to a third rigid part of the printed circuit board substrate onto which a part of the RF antenna extends, the third rigid part being configured to extend in a geometric plane substantially perpendicular to the geometric planes in which the first and the second part extend when the printed circuit board assembly is folded.

The use of a folded printed circuit board assembly means that a more compact and less space-consuming printed circuit board assembly and consumption meter construction can be obtained. This is especially important for flow meters, in which the electronics must be protected from moisture and water, typically be embedding or enclosing the electronics in a watertight enclosure. In this relation, smaller volumes means less production costs.

Folding the printed circuit board as described means that a box-shaped folded assembly with the electronic components places inside the "box", i.e. between the two rigid parts extending in parallel planes, can be obtained. Such a shape of the assembly means that it is well-suited for being installed in many different places, such as consumption meter housings, which are often box-shaped.

Furthermore, the arrangement of the electrical ground plane and the RF antenna on two rigid parts of the printed circuit board substrate, respectively, which extend in two different but substantially parallel geometric planes means that, if the printed circuit board assembly is appropriately oriented within the consumption meter, the ground plane on the first rigid part can be placed between the RF antenna and the flow channel. Thus, the ground plane works as a stable electrical counterweight for the RF antenna and the same type and size of RF antenna can be used for different sizes of consumption meters. In other consumption meters known from the art, this electrical counterweight is formed by the ground plane on a printed circuit board itself and/or a flow channel through which a fluid to be metered flows. In that case, the RF antenna must be dimensioned depending on the size of the consumption meter in order to match the actual electrical counterweight. Furthermore, an electrical counterweight involving a non-conductive flow channel, for instance made of a plastic material, is less stable due to fact that the performance will depend on whether a conductive fluid, such as water, is actually present within the flow channel or not.

Another advantage obtained by orienting the printed circuit board assembly as described is that the RF antenna gets the maximum possible free space in relation to the conductive parts in the consumption meter including the electronic components on the first rigid part of the printed circuit board substrate resulting in optimal radiation characteristics of the RF antenna

Letting the RF antenna extend in two different geometric planes of the folded printed circuit board assembly has surprisingly shown to result in the effect that an RF antenna with a given resonance frequency can be made shorter than otherwise expected, meaning that a more compact printed circuit board assembly, which takes up less space, for instance in an installation box in which the assembly is installed, can be obtained.

In an embodiment of the invention, a second flexible part is arranged to connect the first rigid part and the third rigid part to each other.

Using such configuration, the complete printed circuit board substrate can be produced in one piece, which reduces the production costs.

In an embodiment of the invention, an electrical connector is inserted between the first and the third rigid part of the printed circuit board substrate and arranged to releasably connect the first and the third rigid parts to each other.

The releasable connection between the first and the third rigid part of the printed circuit board substrate to each other means that a given first rigid part of the printed circuit board substrate being equipped with a standard set of electronic components can be combined with different sets of second and third rigid parts comprising RF antennas of different lengths and, thereby, different frequency bands, respectively. Thus, the flexibility of the system is increased.

In an embodiment of the invention, the third rigid part comprises an electrical ground plane.

Letting the electrical ground plane extend onto the third rigid part further increases the counterweight properties of the ground plane and further reduces the influence of the size of the flow channel.

In an embodiment of the invention, the RF antenna extends on the inner side of the folded circuit board assembly, i.e. on the side of the second rigid part of the printed circuit board substrate facing the first rigid part and, where applicable, on the side of the third rigid part of the printed circuit board substrate facing the first and the second rigid parts.

Letting the RF antenna extend on the inner side of the folded circuit board assembly, i.e. on the same side as the electronic components, means that the RF antenna can be connected directly to the relevant electronic components without having the antenna signal passing through the printed circuit board substrate from one side thereof to the other. This is advantageous because the so-called vias used for making electric connections through a printed circuit substrate can be detrimental for high frequency signals due to the fact that the physical structure of the vias causes them to represent uncontrollable inductances.

In an embodiment of the invention, the foldable printed circuit board assembly further comprises a Near Field Communication (NFC) antenna extending mainly on the second rigid part of the printed circuit board substrate.

The inclusion of an NFC antenna enables for simple and easy communication with other electronic devices, for instance for receiving simple commands and the like from external devices. For the NFC antenna, it is even more important than for the RF antenna that the radiation characteristics are optimized as described above.

In an embodiment of the invention, a cutout is made in the second rigid part of the printed circuit board substrate so that a display, which is mounted with the other electronic components on the first rigid part thereof, is clearly visibly through the cutout in the second rigid part, when the printed circuit board assembly is folded.

Such a configuration allows the second rigid part carrying the main part of the RF antenna and, where relevant, also the NFC antenna, to be placed on top of the folded printed circuit board assembly without blocking the sight to the display mounted on the first rigid part arranged there below.

In an embodiment of the invention, the electronic components constitute the necessary electronics to drive and control a consumption meter, such as an ultrasonic flow meter.

In an embodiment of the invention, the consumption meter is an ultrasonic flow meter, such as a water consumption meter, a gas consumption meter or a heat consumption meter.

### Figures

In the following, an exemplary embodiment of the invention is described in more detail with reference to the figures, of which
- Figs. 1a-1c: are a top view, a bottom view and a side view, respectively, of a foldable printed circuit board assembly according to an embodiment of the invention,
- Fig. 2: is a perspective view of the same foldable printed circuit board assembly as shown in Figs. 1a-1c,
- Figs. 3a and 3b: are side views of a foldable printed circuit board assembly according to another embodiment of the invention in an unassembled and unfolded configuration and in an assembled and folded configuration, respectively,
- Fig. 4: is a perspective view of the printed circuit board assembly shown in the previous figures when folded into three geometric planes to form a very compact assembly,
- Fig. 5: is a perspective view of an ultrasonic flow meter according to an embodiment of the invention, and
- Fig. 6: is an exploded view of the same ultrasonic flow meter as shown in Fig. 5.

### Detailed description of the invention

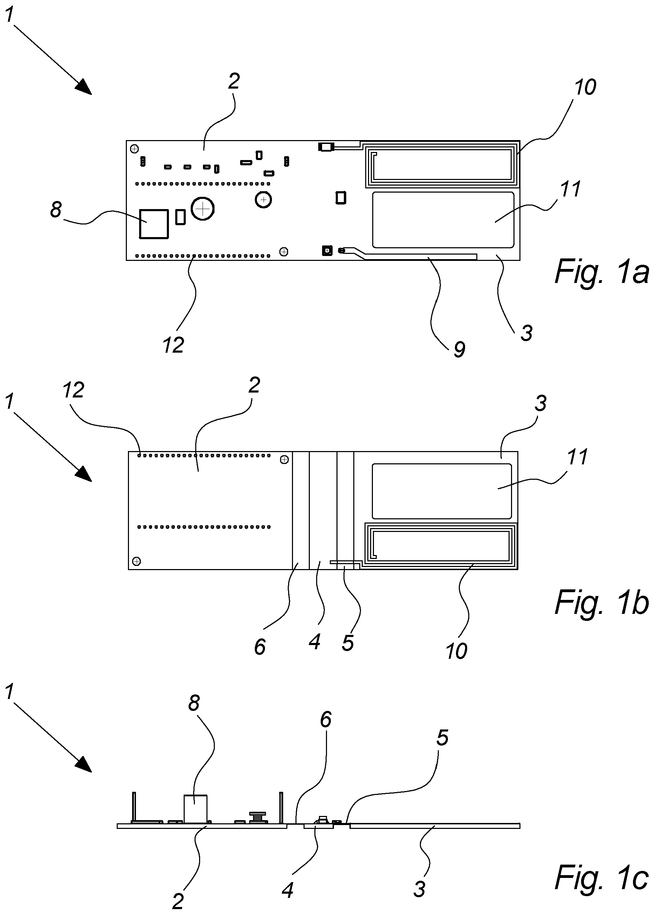

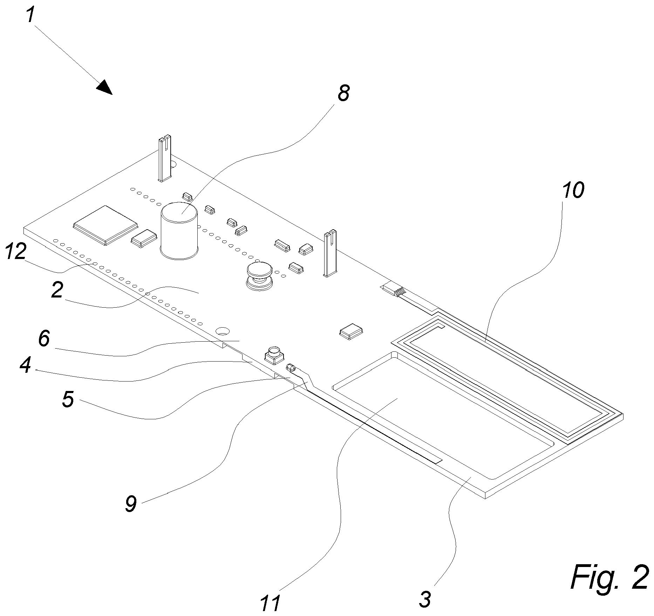

Figs. 1a-1c are a top view, a bottom view and a side view, respectively, of a foldable printed circuit board assembly 1 according to an embodiment of the invention. Fig. 2 is a perspective view of the same foldable printed circuit board assembly 1.

In the illustrated embodiment, a number of electronic components 8, a battery (not specifically indicated in the figures), an NFC antenna 9 and an RF antenna 10 are mounted on a printed circuit board substrate consisting of five different parts 2-6. Three rigid parts 2-4 are separated from each other by two flexible parts 5, 6. The electronic components 8 are mounted on the first rigid part 2 of the printed circuit board substrate, and the two antennas 9, 10 extend mainly on the second rigid part 3 but also partly on the third rigid part 4 of the printed circuit board substrate.

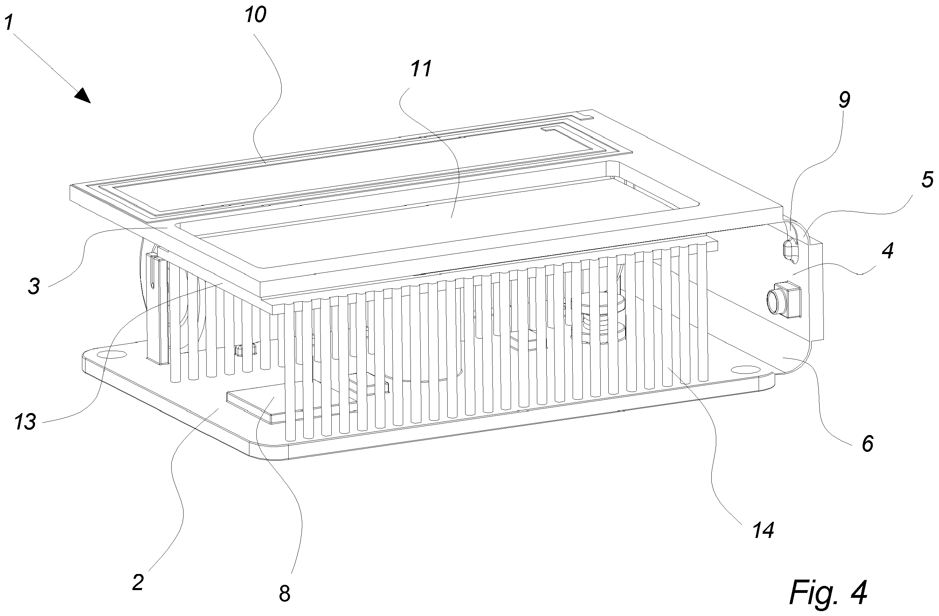

The second rigid part 3 of the printed circuit board substrate comprises a throughgoing cutout 11 to make a display (not shown in any of Figs. 1a-3b) visible through this second rigid part 3, as can be seen in Fig. 4. The first rigid part 2 of the printed circuit board substrate comprises two lines of mounting holes 12 for the mounting and electric contact of this display to the printed circuit board substrate.

The fact that the flexible parts 5, 6 of the printed circuit board substrate are bendable means that the printed circuit board assembly 1 can be folded to form a very compact box-shaped assembly as illustrated in Fig. 4.

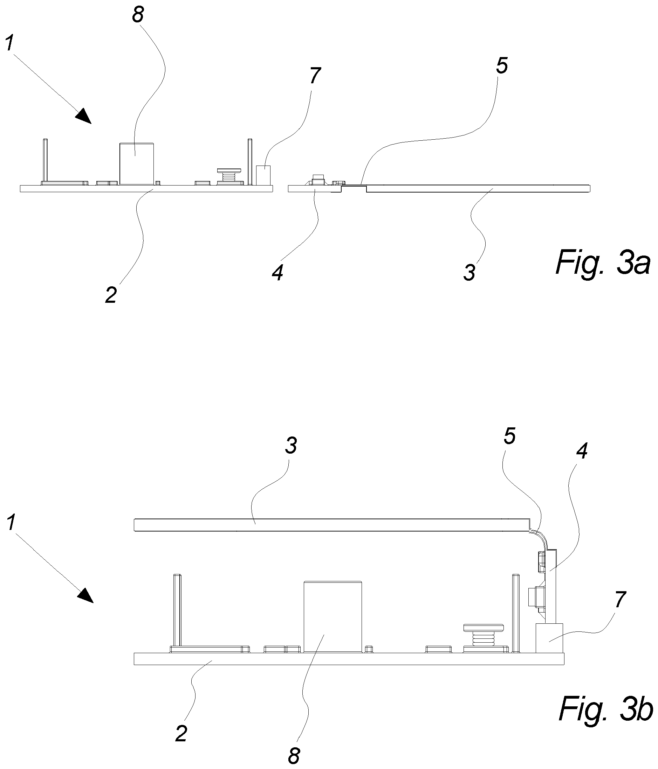

Figs. 3a and 3b show a slightly different embodiment of the printed circuit board assembly in that the second flexible part 6 from the previous figures has been replaced by a connector 7 mounted on the first rigid part 2 of the printed circuit board substrate, into which connector 7 the third rigid part 4 can be fitted to form a physical and electrical connection between these two rigid parts 2, 4. In other embodiments, the connection between the first 2 and third 4 rigid parts may further comprise one or more cables or another flexible part (not shown) along with the connector 7 so that the connection is bendable like the first flexible part 5 rather than fixed in a 90° position as illustrated in Fig. 3b, or the connector 7 may consist of two parts mounted on the two rigid parts 2, 4 of the printed circuit board substrate, respectively.

Fig. 4 is a perspective view of the printed circuit board assembly 1 shown in Figs. 1a-1c and Fig. 2 when folded into three geometric planes to form such a compact box-shaped assembly with the electronic parts 8 extending into the "box" from the bottom thereof, which is formed by the first rigid part 2 of the printed circuit board substrate. The two antennas 9, 10 extend mainly along the top of the "box" formed by the second rigid part 3 of the printed circuit board substrate but also partly on the flexible part 5 and, preferably, on side of the "box", which is formed by the third rigid part 4 of the printed circuit board substrate.

Fig. 4 further illustrates how a display 13 is mounted in the mounting holes 12 of the first rigid part 2 of the printed circuit board substrate, which are illustrated in Figs. 1a and 1b. In the illustrated embodiment, the display 13 is mounted by means of a number of mounting and connection pins 14 so that it forms a "bridge" over at least some of the electronic components 8 and faces upwards against the second rigid part 3 of the printed circuit board assembly. This is why the cutout 11 in the second rigid part 3 is necessary in order to make the display 13 visible from outside the folded printed circuit board assembly 1.

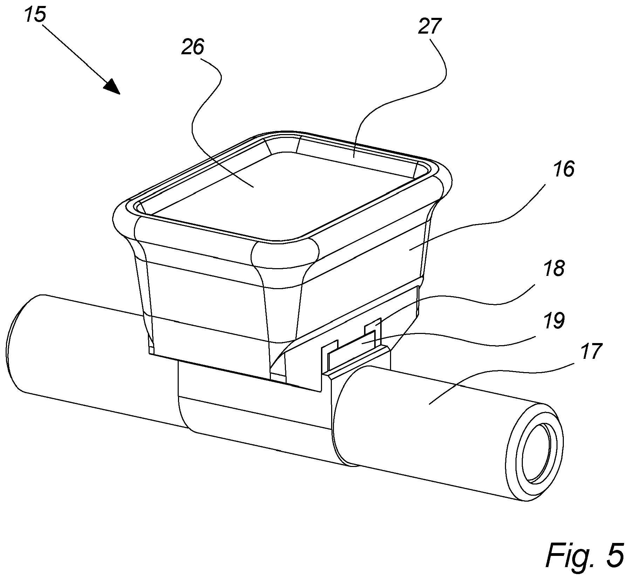

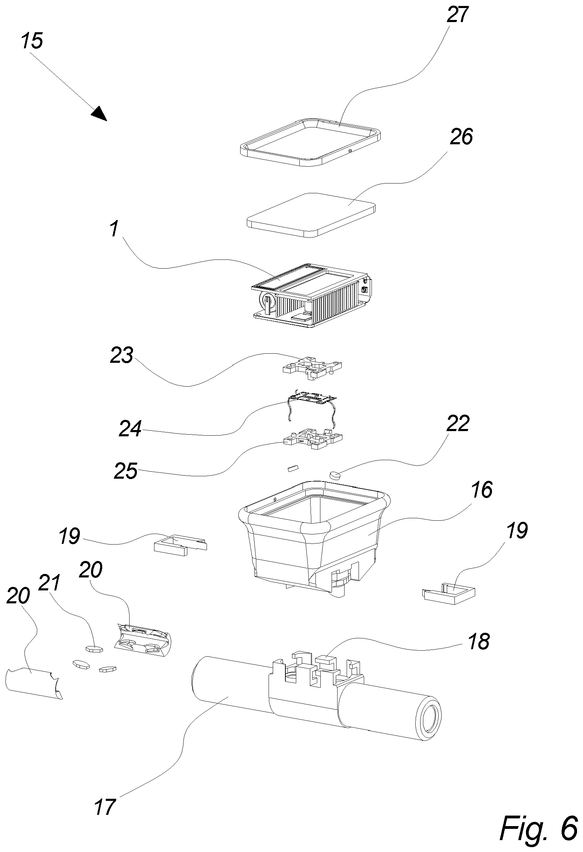

Figs. 5 and 6 are a perspective view and an exploded view, respectively, of an ultrasonic flow meter 15 according to an embodiment of the invention, which comprises a printed circuit board assembly 1 as described above.

As illustrated in Fig. 5, the ultrasonic flow meter 15 basically consists of a housing 16, which is mounted to a flow channel 17 through which the medium to be metered, such as for instance water, flows. The housing 16, which is hermetically sealed by means of a lid 26 and a sealing 27, is mounted to the flow channel 17 by means of a mechanical locking mechanism 18 mounted on the flow channel 17 and a couple of locking pins 19 to be inserted after placing the housing 16 on the locking mechanism 18.

As can be seen from Fig. 6, the housing 16 comprises two ultrasonic transducers 22 and a folded printed circuit board assembly 1 as described above with the necessary electronics and a battery for driving and controlling the function of the flow meter 15 as well as NFC and RF antennas for wireless communication to and from the flow meter 15. A connection arrangement comprising two insulating parts 23, 25 and an electrically conducting part 24 ensures that the ultrasonic transducers 22 are held physically in place and that there is a good electrical contact between the transducers 22 and the electronics in the printed circuit board assembly 1.

Fig. 6 further shows how a flow channel insert 20 with a number of ultrasound reflectors 21 are placed inside the flow channel 17 to ensure a well-defined and controlled path of the ultrasound from one ultrasonic transducer 22 to the other through the medium to be metered.

The illustrated embodiment of an ultrasonic flow meter 15 is just to be seen as one example of consumption meters or other electronic devices in which a folded printed board assembly 1 as described above can be used.

### List of reference numbers

1. Foldable printed circuit board assembly
2. First rigid part of printed circuit board substrate
3. Second rigid part of printed circuit board substrate
4. Third rigid part of printed circuit board substrate
5. First flexible part of printed circuit board substrate
6. Second flexible part of printed circuit board substrate
7. Connector for connecting rigid parts of printed circuit board substrate
8. Electronic components of printed circuit board assembly
9. NFC antenna
10. RF antenna
11. Cutout for display
12. Mounting holes for display pins
13. Display
14. Mounting and connection pins for display
15. Ultrasonic flow meter
16. Housing
17. Flow channel
18. Locking mechanism for housing
19. Locking pin for housing
20. Flow channel insert
21. Ultrasound reflector
22. Ultrasound transducer
23. First insulating part of connection arrangement
24. Conducting part of connection arrangement
25. Second insulating part of connection arrangement
26. Lid for housing
27. Hermetical sealing for housing

## Claims

1. A consumption meter comprising a foldable printed circuit board assembly (1), which foldable printed circuit board assembly comprises a printed circuit board substrate having at least a first (2) and a second (3) rigid part, and a radio frequency (RF) antenna (10) extends mainly on the second rigid part (3),
**characterized in that**
electronic components (8) and a battery are mounted on the first rigid part, which also comprises an electrical ground plane, and
a first flexible part (5) of the printed circuit board substrate being arranged to allow the printed circuit board assembly to be folded so that the first and second rigid parts extend in two different but substantially parallel geometric planes with said electrical ground plane on the first rigid part (2) being located between said radio frequency antenna (10) of said second rigid part (3) and a flow channel (17) through which a fluid to be metered by said consumption meter flows.

2. The consumption meter according to claim 1, wherein the first flexible part connects the second rigid part to a third rigid part (4) of the printed circuit board substrate onto which a part of the RF antenna extends, the third rigid part being configured to extend in a geometric plane substantially perpendicular to the geometric planes in which the first and the second part extend when the printed circuit board assembly is folded.

3. The consumption meter according to claim 2, wherein a second flexible part (6) is arranged to connect the first rigid part and the third rigid part to each other.

4. The consumption meter according to claim 2 or 3, wherein an electrical connector (7) is inserted between the first and the third rigid part of the printed circuit board substrate and arranged to releasably connect the first and the third rigid parts to each other.

5. The consumption meter according to any of claims 2-4, wherein the third rigid part comprises an electrical ground plane.

6. The consumption meter according to any of the preceding claims, wherein the RF antenna extends on the inner side of the folded circuit board assembly, i.e. on the side of the second rigid part of the printed circuit board substrate facing the first rigid part and, where applicable, on the side of the third rigid part of the printed circuit board substrate facing the first and the second rigid parts.

7. The consumption meter according to any of the preceding claims, further comprising a Near Field Communication (NFC) antenna (9) extending mainly on the second rigid part of the printed circuit board substrate.

8. The consumption meter according to any of the preceding claims, wherein a cutout (11) is made in the second rigid part of the printed circuit board substrate so that a display (13), which is mounted with the other electronic components on the first rigid part thereof, is clearly visibly through the cutout in the second rigid part, when the printed circuit board assembly is folded.

9. The consumption meter according to any of the preceding claims, wherein the electronic components constitute the necessary electronics to drive and control a consumption meter, such as an ultrasonic flow meter (15).

10. The consumption meter according to any of the preceding claims, wherein the consumption meter is an ultrasonic flow meter, such as a water consumption meter, a gas consumption meter or a heat consumption meter.

11. A method of manufacturing a consumption meter, comprising the steps of providing a foldable printed circuit board assembly (1); and
folding the foldable printed circuit board assembly (1) so that a first (2) and a second (3) rigid parts extend in two different but substantially parallel geometric planes; and
the foldable printed circuit board assembly comprises a radio frequency (RF) antenna (10) extending mainly on the second part (3);
**characterized in that**
the foldable printed circuit board assembly further comprises
a printed circuit board substrate having at least the first (2) and the second (3) rigid part, wherein electronic components (8) and a battery are mounted on the first rigid part (2), which also comprises an electrical ground plane, and
a first flexible part (5) arranged between said first (2) and second (3) rigid parts to allow the printed circuit board assembly (1) to be folded; and
the method further comprises the step of mounting the foldable printed circuit board assembly (1) inside a housing (16) of said consumption meter so that said electrical ground plane on the first rigid part (2) is located between said radio frequency antenna (10) of said second rigid part (3) and a flow channel (17) through which a fluid to be metered by said consumption meter flows.

12. The method of manufacturing according to claim 11, wherein the first flexible part (5) connects the second rigid part (3) to a third rigid part (4) of the printed circuit board substrate onto which a part of the RF antenna (10) extends, the third rigid part (4) being configured to extend in a geometric plane substantially perpendicular to the geometric planes in which the first (2) and the second (3) part extend when the printed circuit board assembly is folded.

13. The method of manufacturing according to claim 12, wherein an electrical connector (7) is inserted between the first (2) and the third (4) rigid part of the printed circuit board substrate and arranged to releasably connect the first (2) and the third (4) rigid parts to each other.

14. The method of manufacturing according to any of the claims 11 to 13, wherein the foldable printed circuit board assembly (1) further comprises a Near Field Communication (NFC) antenna (9) extending mainly on the second rigid part (3) of the printed circuit board substrate.

15. The method of manufacturing according to any of the claims 11 to 14, comprising the steps of:
mounting a display (13) with the other electronic components (8) on the first rigid part (2); and
making a cutout (11) in the second rigid part (3) of the printed circuit board substrate so that the display (13) is clearly visibly through the cutout (11) in the second rigid part (3), when the printed circuit board assembly (1) is folded.

## Patentansprüche

1. Verbrauchszähler, der eine faltbare Leiterplatteneinheit (1) umfasst, wobei die faltbare Leiterplatteneinheit eine Leiterplatten-Basisplatte umfasst, die wenigstens einen ersten (2) und einen zweiten (3) unbiegsamen Teil hat, und wobei eine Hochfrequenz (RF) Antenne (10) sich hauptsächlich auf dem zweiten unbiegsamen Teil (3) erstreckt,
**dadurch gekennzeichnet, dass**
elektronische Komponenten (8) und eine Batterie auf dem ersten unbiegsamen Teil montiert sind, der auch eine elektrische Masseplatte umfasst, und
wobei ein erster biegsamer Teil (5) der Leiterplatten-Basisplatte dafür eingerichtet ist, es der Leiterplatteneinheit zu gestatten gefaltet zu werden, derart, dass der erste und zweite unbiegsame Teil sich in zwei verschiedenen aber im Wesentlichen parallelen geometrischen Ebenen erstrecken, wobei die elektrische Masseplatte auf dem ersten unbiegsamen Teil (2) sich zwischen der Hochfrequenzantenne (10) des zweiten unbiegsamen Teils (3) und einem Durchflusskanal (17) befindet, durch den ein von dem Verbrauchszähler zu messendes Fluid fließt.

2. Verbrauchszähler nach Anspruch 1, wobei der erste biegsame Teil den zweiten unbiegsamen Teil mit einem dritten unbiegsamen Teil (4) der Leiterplatten-Basisplatte verbindet, auf dem sich ein Teil der RF-Antenne erstreckt, wobei der dritte unbiegsame Teil dafür eingerichtet ist, sich in einer geometrischen Ebene zu erstrecken, die im Wesentlichen senkrecht zu den geometrischen Ebenen steht, in denen sich der erste und der zweite Teil erstrecken, wenn die Leiterplatteneinheit gefaltet ist.

3. Verbrauchszähler nach Anspruch 2, wobei ein zweiter biegsamer Teil (6) dafür eingerichtet ist, den ersten unbiegsamen Teil und den dritten unbiegsamen Teil miteinander zu verbinden.

4. Verbrauchszähler nach Anspruch 2 oder 3, wobei ein elektrischer Konnektor (7) zwischen dem ersten und dem dritten unbiegsamen Teil der Leiterplatten-Basisplatte eingefügt und dafür eingerichtet ist, den ersten und den dritten unbiegsamen Teil abtrennbar miteinander zu verbinden.

5. Verbrauchszähler nach einem der Ansprüche 2 bis 4, wobei der dritte unbiegsame Teil eine elektrische Masseplatte umfasst.

6. Verbrauchszähler nach einem der vorhergehenden Ansprüche, wobei die RF-Antenne sich auf der Innenseite der gefalteten Leiterplatteneinheit erstreckt, das heißt auf der Seite des zweiten unbiegsamen Teils der Leiterplatten-Basisplatte, die dem ersten unbiegsamen Teil zugewandt ist, und, falls anwendbar, auf der Seite des dritten unbiegsamen Teils der Leiterplatten-Basisplatte, die dem ersten und dem zweiten unbiegsamen Teil zugewandt ist.

7. Verbrauchszähler nach einem der vorhergehenden Ansprüche, der außerdem eine Antenne (9) zur Nahfeldkommunikation (NFC) umfasst, die sich hauptsächlich auf dem zweiten unbiegsamen Teil der Leiterplatten-Basisplatte erstreckt.

8. Verbrauchszähler nach einem der vorhergehenden Ansprüche, wobei im zweiten unbiegsamen Teil der Leiterplatten-Basisplatte ein Ausschnitt (11) ausgeführt ist, derart, dass ein Display (13), das mit den weiteren elektronischen Komponenten auf deren erstem unbiegsamen Teil montiert ist, durch den Ausschnitt im zweiten unbiegsamen Teil deutlich sichtbar ist, wenn die Leiterplatteneinheit gefaltet ist.

9. Verbrauchszähler nach einem der vorhergehenden Ansprüche, wobei die elektronischen Komponenten die notwendige Elektronik bilden, um einen Verbrauchszähler, wie etwa einen Ultraschall-Durchflussmesser (15), zu versorgen und zu steuern.

10. Verbrauchszähler nach einem der vorhergehenden Ansprüche, wobei der Verbrauchszähler ein Ultraschall-Durchflussmesser ist, wie etwa ein Wasser-Verbrauchszähler, ein Gas-Verbrauchszähler oder ein Wärme-Verbrauchszähler.

11. Verfahren zum Herstellen eines Verbrauchszählers, die folgenden Schritte umfassend:
Bereitstellen einer faltbaren Leiterplatteneinheit (1); und
Falten der faltbaren Leiterplatteneinheit (1), derart, dass ein erster (2) und ein zweiter (3) unbiegsamer Teil sich in zwei verschiedenen aber im Wesentlichen parallelen geometrischen Ebenen erstrecken; und
wobei die faltbare Leiterplatteneinheit eine Hochfrequenz (RF) Antenne (10) umfasst, die sich hauptsächlich auf dem zweiten Teil (3) erstreckt;
**dadurch gekennzeichnet, dass**
die faltbare Leiterplatteneinheit außerdem Folgendes umfasst:
eine Leiterplatten-Basisplatte, die wenigstens den ersten (2) und den zweiten (3) unbiegsamen Teil hat, wobei elektronische Komponenten (8) und eine Batterie auf dem ersten unbiegsamen Teil (2) montiert sind, der auch eine elektrische Masseplatte umfasst, und
einen ersten biegsamen Teil (5), der zwischen dem ersten (2) und zweiten (3) unbiegsamen Teil angeordnet ist, um es der Leiterplatteneinheit (1) zu gestatten gefaltet zu werden; und
wobei das Verfahren außerdem einen Schritt umfasst zum Montieren der faltbaren Leiterplatteneinheit (1) in einem Gehäuse (16) des Verbrauchszählers, derart, dass die elektrische Masseplatte auf dem ersten unbiegsamen Teil (2) sich zwischen der Hochfrequenzantenne (10) des zweiten unbiegsamen Teils (3) und einem Durchflusskanal (17) befindet, durch den ein von dem Verbrauchszähler zu messendes Fluid fließt.

12. Verfahren zum Herstellen nach Anspruch 11, wobei der erste biegsame Teil (5) den zweiten unbiegsamen Teil (3) mit einem dritten unbiegsamen Teil (4) der Leiterplatten-Basisplatte verbindet, auf dem sich ein Teil der RF-Antenne (10) erstreckt, wobei der dritte unbiegsame Teil (4) dafür eingerichtet ist, sich in einer geometrischen Ebene zu erstrecken, die im Wesentlichen senkrecht zu den geometrischen Ebenen steht, in denen sich der erste (2) und der zweite Teil (3) erstrecken, wenn die Leiterplatteneinheit gefaltet ist.

13. Verfahren zum Herstellen nach Anspruch 12, wobei ein elektrischer Konnektor (7) zwischen dem ersten (2) und dem dritten (4) unbiegsamen Teil der Leiterplatten-Basisplatte eingefügt und dafür eingerichtet ist, den ersten (2) und den dritten (4) unbiegsamen Teil abtrennbar miteinander zu verbinden.

14. Verfahren zum Herstellen nach einem der Ansprüche 11 bis 13, wobei die faltbare Leiterplatteneinheit (1) außerdem eine Antenne (9) zur Nahfeldkommunikation (NFC) umfasst, die sich hauptsächlich auf dem zweiten unbiegsamen Teil (3) der Leiterplatten-Basisplatte erstreckt.

15. Verfahren zum Herstellen nach einem der Ansprüche 11 bis 14, die folgenden Schritte umfassend:
Montieren eines Displays (13) mit den weiteren elektronischen Komponenten (8) auf dem ersten unbiegsamen Teil (2); und
Ausführen eines Ausschnitts (11) im zweiten unbiegsamen Teil (3) der Leiterplatten-Basisplatte, derart, dass das Display (13) durch den Ausschnitt (11) im zweiten unbiegsamen Teil (3) deutlich sichtbar ist, wenn die Leiterplatteneinheit (1) gefaltet ist.

## Revendications

1. Compteur de consommation comprenant un assemblage de carte de circuit imprimé pliable (1), lequel assemblage de carte de circuit imprimé pliable comprend un substrat de carte de circuit imprimé ayant au moins une première (2) et une deuxième (3) partie rigide, et une antenne radiofréquence (RF) (10) s'étend principalement sur la deuxième partie rigide (3),
**caractérisé en ce que**
des composants électroniques (8) et une batterie sont montés sur la première partie rigide, qui comprend également un plan de masse électrique, et
une première partie flexible (5) du substrat de carte de circuit imprimé étant agencée pour permettre à l'assemblage de carte de circuit imprimé de se plier de sorte que les première et deuxième parties rigides s'étendent dans deux plans géométriques différents mais sensiblement parallèles avec ledit plan de masse électrique sur la première partie rigide (2) située entre ladite antenne radiofréquence (10) de ladite deuxième partie rigide (3) et un canal d'écoulement (17) à travers lequel un fluide à mesurer par ledit compteur de consommation s'écoule.

2. Compteur de consommation selon la revendication 1, dans lequel la première partie flexible connecte la deuxième partie rigide à une troisième partie rigide (4) du substrat de carte de circuit imprimé sur lequel une partie de l'antenne RF s'étend, la troisième partie rigide étant configurée pour s'étendre dans un plan géométrique sensiblement perpendiculaire aux plans géométriques dans lesquels la première et la deuxième partie s'étendent lorsque l'assemblage de carte de circuit imprimé est plié.

3. Compteur de consommation selon la revendication 2, dans lequel une seconde partie flexible (6) est agencée pour connecter la première partie rigide et la troisième partie rigide l'une à l'autre.

4. Compteur de consommation selon la revendication 2 ou 3, dans lequel un connecteur électrique (7) est inséré entre la première et la troisième partie rigide du substrat de carte de circuit imprimé et agencé pour connecter de façon libérable la première et la troisième partie rigide l'une à l'autre.

5. Compteur de consommation selon l'une quelconque des revendications 2 à 4, dans lequel la troisième partie rigide comprend un plan de masse électrique.

6. Compteur de consommation selon l'une quelconque des revendications précédentes, dans lequel l'antenne RF s'étend sur le côté interne de l'assemblage de carte de circuit plié, c.-à-d. sur le côté de la deuxième partie rigide du substrat de carte de circuit imprimé en regard de la première partie rigide et, lorsque cela est applicable, sur le côté de la troisième partie rigide du substrat de carte de circuit imprimé en regard des première et deuxième parties rigides.

7. Compteur de consommation selon l'une quelconque des revendications précédentes, comprenant en outre une antenne de communication en champ proche (NFC) (9) s'étendant principalement sur la deuxième partie rigide du substrat de carte de circuit imprimé.

8. Compteur de consommation selon l'une quelconque des revendications précédentes, dans lequel une échancrure (11) est pratiquée dans la deuxième partie rigide du substrat de carte de circuit imprimé de sorte qu'un afficheur (13), qui est monté avec les autres composants électroniques sur la première partie rigide de celui-ci, est clairement visible à travers l'échancrure dans la deuxième partie rigide, lorsque l'assemblage de carte de circuit imprimé est plié.

9. Compteur de consommation selon l'une quelconque des revendications précédentes, dans lequel les composants électroniques constituent l'électronique nécessaire pour piloter et commander un compteur de consommation, tel qu'un débitmètre ultrasonore (15).

10. Compteur de consommation selon l'une quelconque des revendications précédentes, dans lequel le compteur de consommation est un débitmètre ultrasonore, tel qu'un compteur de consommation d'eau, un compteur de consommation de gaz ou un compteur de consommation de chaleur.

11. Procédé de fabrication d'un compteur de consommation, comprenant les étapes de
fourniture d'un assemblage de carte de circuit imprimé pliable (1) ; et
pliage de l'assemblage de carte de circuit imprimé pliable (1) de sorte qu'une première (2) et une deuxième (3) partie rigide s'étendent dans deux plans géométriques différents mais sensiblement parallèles ; et
l'assemblage de carte de circuit imprimé pliable comprend une antenne radiofréquence (RF) (10) s'étendant principalement sur la deuxième partie (3) ; **caractérisé en ce que**
l'assemblage de carte de circuit imprimé pliable comprend en outre un substrat de carte de circuit imprimé comportant au moins la première (2) et la deuxième (3) partie rigide, dans lequel des composants électroniques (8) et une batterie sont montés sur la première partie rigide (2), qui comprend également un plan de masse électrique, et
une première partie flexible (5) agencée entre lesdites première (2) et deuxième (3) parties rigides pour permettre de plier l'assemblage de carte de circuit imprimé (1) ; et
le procédé comprend en outre l'étape de montage de l'assemblage de carte de circuit imprimé pliable (1) à l'intérieur d'un logement (16) dudit compteur de consommation de telle sorte que ledit plan de masse électrique sur la première partie rigide (2) est situé entre ladite antenne radiofréquence (10) de ladite deuxième partie rigide (3) et un canal d'écoulement (17) à travers lequel un fluide à mesurer par ledit compteur de consommation s'écoule.

12. Procédé de fabrication selon la revendication 11, dans lequel la première partie flexible (5) connecte la deuxième partie rigide (3) à une troisième partie rigide (4) du substrat de carte de circuit imprimé sur lequel une partie de l'antenne RF (10) s'étend, la troisième partie rigide (4) étant configurée pour s'étendre dans un plan géométrique sensiblement perpendiculaire aux plans géométriques dans lesquels la première (2) et la deuxième (3) partie s'étendent lorsque l'assemblage de carte de circuit imprimé est plié.

13. Procédé de fabrication selon la revendication 12, dans lequel un connecteur électrique (7) est inséré entre la première (2) et la troisième (4) partie rigide du substrat de carte de circuit imprimé et agencé pour connecter de façon libérable la première (2) et la troisième (4) partie rigide l'une à l'autre.

14. Procédé de fabrication selon l'une quelconque des revendications 11 à 13, dans lequel l'assemblage de carte de circuit imprimé pliable (1) comprend en outre une antenne de communication en champ proche (NFC) (9) s'étendant principalement sur la deuxième partie rigide (3) du substrat de carte de circuit imprimé.

15. Procédé de fabrication selon l'une quelconque des revendications 11 à 14, comprenant les étapes de :
montage d'un afficheur (13) avec les autres composants électroniques (8) sur la première partie rigide (2) ; et
pratique d'une échancrure (11) dans la deuxième partie rigide (3) du substrat de carte de circuit imprimé de sorte que l'afficheur (13) est clairement visible à travers l'échancrure (11) dans la deuxième partie rigide (3), lorsque l'assemblage de carte de circuit imprimé (1) est plié.
